# EUROPEAN PATENT APPLICATION

(11) **EP 3 148 078 A1**
(43) Date of publication of application: **29.03.2017**
(21) Application number: 15465541.9
(22) Date of filing: 22.09.2015
(51) Int. Cl.: H03K 17/687, H03K 17/082, B60T 8/36, H01H 47/32

(54) **INTEGRATED CIRCUIT FOR DRIVING A SOLENOID**

(71) Applicant: Continental Automotive GmbH, 30165 Hannover (DE)
(72) Inventor: Pandelica, Adrian Ovidiu, Sibiu (RO); Pandelica, Gabriela, Sibiu (RO); Simion, Razvan, 550336 Sibiu (RO)

(57) **Abstract**

The invention concerns an integrated circuit (1) adapted to drive a solenoid current through one solenoid (2) connectable between a high side solenoid output (3) and a low side solenoid output (4). The ASIC comprises an input logic (20) connected with a control input (8) switching the solenoid current, with a high side switch (14) controlling the high side solenoid output (3) and with a low side switch (15) controlling the low side solenoid output (4).

## Description

Solenoids are often used to operate actuators such as valves, levers or rods. From the state of the art, discrete drive electronics are known to drive, or control, solenoids. Also, integrated circuits are known that are adapted to independently drive a plurality of solenoids. For example, integrated circuits are known that are adapted to drive four or eight solenoids independently.

It is an object of the present invention to provide improved driver electronics for driving solenoids and to provide driver electronics that is cost-efficient for driving, or controlling, a single solenoid.

The object is achieved by an integrated circuit according to claim 1.

Preferred embodiments of the invention are given in the dependent claims.

According to the invention an integrated circuit adapted to drive a solenoid current through one solenoid connectable between a high side solenoid output and a low side solenoid output of the integrated circuit comprises a control input, an input logic, a high side switch and a low side switch. The control input is connected with the input logic. The input logic controls the high side switch and the low side switch. The high side switch is arranged between the high side solenoid output and a power voltage. The low side switch is arranged between the low side solenoid output and ground.

When the control input is activated, the input logic controls the high side switch such that it connects the power voltage with the high side solenoid output, thus controlling the high side solenoid output.

Likewise, the input logic controls the low side switch such that it connects the low side output with ground, thus controlling the low side solenoid output. Thus, a solenoid current is driven through the solenoid connected between the high and low side outputs of the integrated circuit.

Thus, a solenoid and any actuator such as a valve, a lever or a rod driven by a solenoid can be controlled easily by the integrated circuit.

As an advantage, an integrated circuit is more cost-efficient in terms of cost of goods and in terms of development effort compared with a solution based on discrete electronics known from the state of the art. It is particularly advantageous that the test effort is reduced by the invention since an already tested circuitry is re-usable for a variety of different solenoid applications. Also, the number of input and output pins as well as the susceptibility to problems with the electromagnetic compatibility are reduced compared to discrete electronics known from the state of the art. Further, the space for the footprint required on a printed circuit board is reduced. Also, the placing and soldering costs are reduced due to the fact that only one component is mounted instead of a plurality of components, like for instance tens of components.

As an advantage over integrated circuits known from the state of the art that drive a plurality of solenoids, the invention provides a more cost-efficient driver for driving a single solenoid or a number of solenoids that differs from the number of solenoids such an integrated circuit is designed for.

In an embodiment of the invention, the integrated circuit comprises at least one current sensor measuring the solenoid current and a power control circuit for regulating the solenoid current to a configurable set-point value. The at least one current sensor may be arranged in the high side solenoid current path between the power voltage and the high side solenoid output. The at least one current sensor may also be arranged in the low side solenoid current path between the low side solenoid output and ground. For protection against short circuit to battery and/or ground of the solenoid outputs, both current sensors are implemented. It is possible to use only one of the both current sensors for current measurement.

The power control circuit is arranged between the input logic and the high and low side switches. The power control circuit controls the high and/or the low side switch such that the solenoid current passing through and measured by the at least one current sensor is within a predetermined control deviation from the set-point solenoid current value.

The set-point solenoid current value is configurable by an input for current threshold set. The input for current threshold set measures an analog input voltage value. According to a predetermined correspondence or function, the set-point solenoid current is determined from this analog input voltage value.

As an advantage of this embodiment the solenoid current can be adapted to the requirements of a specific solenoid and a specific application, e.g. a specific type of valve to be driven by the solenoid. As a further advantage, the number of pins or contacts required to configure the solenoid current is reduced compared with a discrete electronics driver or compared with an integrated circuit driver for a plurality of solenoids.

In an embodiment of the invention, the integrated circuit comprises an oscillator which generates a pulse width modulated (PWM) oscillation that controls the solenoid current. The PWM oscillation is fed into the power control circuit. Those skilled in the art know that controlling a gate such as a field effect transistor by a PWM oscillation with variable duty cycle and/or variable frequency results in a current through such a gate that is determined by the duty cycle and the frequency of the PWM oscillation.

In an embodiment of the invention, the integrated circuit is adapted to operate in a closed control loop for controlling the current through the high side solenoid output and/or the current through the low side solenoid output. Such a closed control loop can be implemented in the integrated circuit itself.

In another embodiment, such a closed control loop is implemented in an external controller. The external controller has a measuring input that provides the controlled variable to the control loop. The external controller furthermore has a control output that provides the reference variable derived from the control loop. The measuring input and the control output of the external controller are connected with the analog output for current sensing and with the control input, respectively, of the integrated circuit. The external controller may be formed as a microcontroller.

As an advantage, a predetermined, for example a substantially constant, solenoid current can be delivered by an integrated circuit according to this embodiment.

The present invention will become more fully understood from the detailed description given here in below and the accompanying drawings which are given by way of illustration only, and thus, are not limitative of the present invention, and wherein:
- Figure 1: is a schematic circuit diagram of components of an integrated circuit and
- Figure 2: is a schematic diagram of a closed control loop formed by an integrated circuit and an external controller.

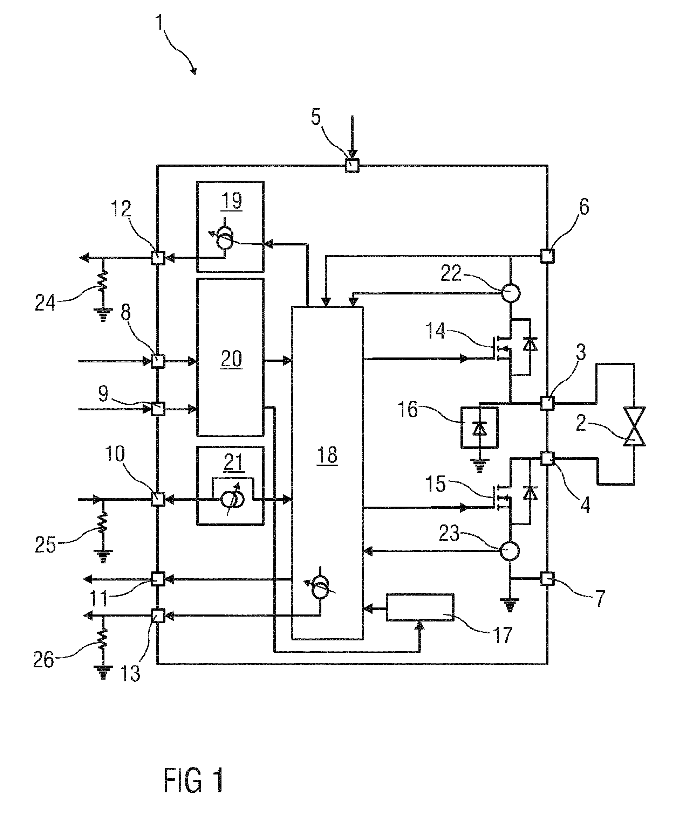

The integrated circuit 1 shown in Figure 1 drives a solenoid 2 connected between a high side solenoid output 3 and a low side solenoid output 4. The integrated circuit 1 is powered by a supply voltage for digital electronics, such as 3.3 Volt or 5 Volt, provided on the digital supply voltage input 5. A positive power voltage for powering the solenoid 2 is provided on the power stage voltage input 6. This power voltage, such as 12 Volt or a voltage up to 48 Volt, may be provided by a battery of a car. All voltages are measured relative to a ground 7. The integrated circuit 1 may be formed as an application specific integrated circuit (ASIC).

The integrated circuit 1 provides the following inputs: a digital control input 8, an analog current regulation mode input 9 and an analog input for current threshold set 10.

In addition to the solenoid outputs 3, 4 the integrated circuit 1 provides the following outputs: a digital fault detection output 11, an analog output for current sensing 12 and an analog fault diagnosis output 13.

Digital inputs and outputs may be assigned a high level or logic "1" that corresponds to the voltage at the digital supply voltage input 5 or a low level or logic "0" that corresponds to ground 7. Digital inputs may also be left open.

The integrated circuit 1 comprises a high side switch 14, a low side switch 15, a freewheeling diode 16, an internal oscillator 17, a power control circuit 18, a controllable current source for current sense output 19, a digital input logic 20 and a controllable current source for current threshold input 21.

The digital input logic 20 is controlled by the control input 8 and by the current regulation mode input 9 and is connected with the power control circuit 18 and with the internal oscillator 17. The current source for current threshold input 21 is controlled by the input for current threshold set 10 and connected with the power control circuit 18.

The operation of the integrated circuit 1 and the interaction of its components will be explained in more detail in the following. Firstly, the operation of the integrated circuit 1 to control the solenoid 2 will be explained. Thereafter, diagnosis and protection functions of the integrated circuit 1 will be explained. The solenoid current through the solenoid 2 connected with the integrated circuit 1 is switched on and off by the control input 8 which is connected with the input logic 20 of the integrated circuit 1. One output of the input logic 20 is connected with the power control circuit 18 that drives an output stage formed by a high side switch 14 and a low side switch 15. The high and low side switches 14, 15 can be controlled to connect or disconnect the high and low side solenoid outputs 3, 4 with the power stage voltage input 6 and with ground 7, respectively.

When the control input 8 is switched on by assigning a high level input to it, the input logic 20 causes the power control circuit 18 to control both the high side and the low side switch 14, 15 to connect through. Thereby a solenoid current flows from the power stage voltage input 6 through the high side solenoid output 3 into the solenoid 2 and backwards to the integrated circuit 1 through the low side solenoid output 4 towards ground 7. By this solenoid current the solenoid 2 is activated and, for example, a valve is opened by the solenoid 2.

When the control input 8 is switched off by assigning a low level to it, the gates 14, 15 are controlled such that they disconnect the solenoid 2 from the power voltage 6 and intermit the solenoid current. Thereby, the solenoid 2 is deactivated and, for example, a valve controlled by it is closed.

The high side switch 14 and the low side switch 15 can be formed as field effect transistors (FETs) or as metal-oxide-semiconductor field effect transistors (MOSFETs) by any other switching means such as bipolar transistors or thyristors.

The freewheeling diode 16 is connected in inverse direction between the high side solenoid output 3 and ground 7 in order to protect the output stage from negative voltages induced in the solenoid 2 when disconnecting it from the positive power voltage 6.

For many applications of solenoids 2, for example in safety-critical automotive applications, a monitoring of the status of the solenoid 2, in particularity a detection of fault conditions is important. Also, it may be advantageous to control the value, i.e. the intensity, of the solenoid current. In the following, further details of the integrated circuit 1 are described that serve these purposes.

Current sensors 22, 23 are arranged in the solenoid current path on the high side between the high side switch 14 and the power stage voltage input 6 and on the low side between the low side switch 15 and ground 7, respectively. The current sensors 22, 23 provide current measurement values to the power control circuit 18. The power control circuit 18 drives the controllable current source for current sense output 19 to deliver a sensing output current through the analog output for current sensing 12 of the integrated circuit 1. Advantageously, the sensing output current is weaker but proportional to the measured solenoid current. Thus, a voltage over an external analog current sensing resistor 24 attached between the analog output for current sensing 12 and ground 7 can be measured that is proportional to the solenoid current. Thereby the solenoid current can be monitored easily and independently from the integrated circuit 1.

A set-point value for the solenoid current to be controlled by the integrated circuit 1 is determined by the input assignment of an input for current threshold set 10. For example, the input for current threshold set 10 may be connected with the controllable current source for current threshold input 21 inside the integrated circuit 1 and with a current threshold set resistor 25 towards ground 7 outside the integrated circuit 1. Thereby, the voltage at the input for current threshold set 10 is proportional to the current threshold set resistor 25. That voltage is measured and feed to the power control circuit 18. The power control circuit 18 drives the switches 14, 15, such that a solenoid current is adjusted that is proportional to the voltage at the input for current threshold set 10. As an advantage, in this embodiment the solenoid current can easily be configured by choosing the current threshold set resistor 25 according to a predetermined proportionality. As an example, said predetermined proportionality may be chosen such that the set-point value for the solenoid current in ampere equals the resistance value of the current threshold set resistor 25 in kiloohms, such that a desired solenoid current can be simply configured by connecting a current threshold set resistor 25 according to this predetermined proportionality.

It is possible to control the solenoid current by means of a pulse-width modulated (PWM) signal generated from an internal oscillator 17, wherein the inverse of the period of such a PWM signal is denoted as the PWM frequency and wherein the percentage of one period in which the PWM signal is set to a high level or "1" is denoted as duty cycle. The clock frequency of the internal oscillator 17 can be determined by a current regulation mode input 9. The current regulation mode input 9 is connected with the input logic 20 that, depending on its input state, controls the clock frequency of the internal oscillator 17. As an example, the clock frequency of the internal oscillator 17 is set to 3 kilohertz if the current regulation modeinput 9 is assigned to a high level whereas the clock frequency is set to 5 kilohertz if the current regulation mode input 9 is not assigned an input voltage, i.e. if it is left open.

The internal oscillator 17, and thus the internal regulation of the solenoid current by a PWM signal generated by it, is disabled if the current regulation mode input 9 is set to a low level. In this embodiment the PWM signal is provided by an external PWM signal source through the control input 8. Such an external PWM signal source may be formed as a microcontroller. Such a microcontroller may read the instantaneous value of the current through the solenoid 2 on the analog output for current sensing 12 of the integrated circuit 1.

In this way, the microcontroller can regulate the current through the solenoid 2 to a set value by tuning the duty cycle and the PWM frequency of the external PWM signal provided on the control input 8. In this embodiment, the input for current threshold set 10 only sets a current protection threshold that is used to detect an overcurrent through the solenoid 2 as will be explained in more detail later on.

By the variation of the PWM frequency enabled by this embodiment, minimum frequency requirements of the solenoid 1 due to mechanical vibration can be met. As another advantage, the power dissipation within the integrated circuit 1 may be reduced by lowering the PWM frequency.

The integrated circuit 1 is equipped with an internal diagnosis and protection function to diagnose over-current or short-circuit and to prevent damaging or malfunctioning of the solenoid 2 or of an actuator such as a valve driven by it. The power control circuit 18 compares the set-point value for the solenoid current, i.e. the desired solenoid current as derived from the input for current threshold set 10 with the current values measured by the current sensors 22, 23. A current threshold is determined from the set-point current value, for example by multiplication with a predetermined factor greater than one in order to achieve a safety margin for the internal solenoid current regulation. For example, a predetermined factor of 1.2 multiplied with the set-point current value may form a limit for the detection of an overcurrent, while a predetermined factor of 2 multiplied with the set-point current value may form a limit for the detection of a short circuit current.

If the measured solenoid current value exceeds the current threshold, a digital fault detection output 11 is set to a low level by the power control circuit 18, wherein a low level indicates a fault condition of the integrated circuit 1 and a high level of the digital fault detection output 11 indicates normal operation. Likewise, it is possible to choose a current threshold in such a way that the digital fault detection output 11 is set to a high level in the presence of a fault, while it is set to a low level in normal operation.

Different variations of a fault condition are possible. As an example, a solenoid current that exceeds the current threshold but that does not exceed a value twice the current threshold may be characterized as over-current, whereas a solenoid current that exceeds a value twice the current threshold may be characterized as short-circuit. As different variations of a fault condition may have different reasons and may require different protection measures, a discrimination of such variations is of advantage.

For example, when the high side current sensor 22 measures a current that is substantially, e.g. by a factor of 2 or more, lower than the current measured by the low side current sensor 23, a short circuit between the high side solenoid output 3 and the power voltage 6 may be diagnosed. Likewise, when the low side current sensor 23 measures a current that is substantially lower than the high side current sensor 22, a short circuit between the low side solenoid output 4 and ground 7 may be diagnosed.

More specific information on the type of the fault condition is therefore provided by the analog fault diagnosis output 13 driven by the power control circuit 18. The analog fault diagnosis output 13 may be driven by a controllable current source inside the power control circuit 18 such that certain different current values generated by the controllable current source correspond to different types of fault conditions. Thereby, the voltage over an external diagnosis sensing resistor 26 connected between the analog fault diagnosis output 13 and ground 7 is proportional to the current generated by the internal controllable current source of the power control circuit 18. This voltage then indicates the type of fault condition in a way that is particularly easy to measure and evaluate.

By way of example, the following correspondences can be predetermined for certain types of fault conditions and output currents through the analog fault diagnosis output in the presence of low level at the digital fault detection output 11:
- an output current of 0.275 milliampere corresponds to the low side solenoid output 4 short-circuited towards ground 7,
- an output current of 0.825 milliampere corresponds to the high side solenoid output 3 short-circuited towards ground 7,
- an output current of 1.375 milliampere corresponds to the low side solenoid output 4 short-circuited towards power stage voltage input 6,
- an output current of 1.925 milliampere corresponds to the high side solenoid output 3 short-circuited towards power stage voltage input 6,
- an output current of 2.475 milliampere corresponds to an open load between high and low side solenoid outputs 3, 4 and
- an output current of 3.025 milliampere corresponds to an over-current through and low side solenoid outputs 3, 4
- an output current of 3.575 milliampere corresponds to an undervoltage condition of the power stage voltage input 6
- an output current of 4.125 milliampere corresponds to an overvoltage condition of the power stage voltage input 6.

Those skilled in the art will appreciate that output current values according to said correspondence may be substituted by non-overlapping ranges of output current values in order to improve the robustness of the evaluation of a fault diagnosis.

The analog fault diagnosis output 13 is intended to be ignored if the digital fault detection output 11 indicates normal operation of the integrated circuit 1 by an external controlling circuit such as an microcontroller.

On detection of a fault condition, the power control circuit 18 furthermore disconnects the high side solenoid output 3 from the power stage voltage input 6 and the low side solenoid output 4 from ground 7, thereby isolating the solenoid 2 and protecting it from an excess current. Further, an external cable connecting the solenoid 2 with the integrated circuit 1 is protected from damage caused by an excess current. The integrated circuit 1 resumes its normal operation and resets the digital fault detection output 11 when the control input 8 is assigned a low level for a predetermined time span, for example for at least 100 milliseconds.

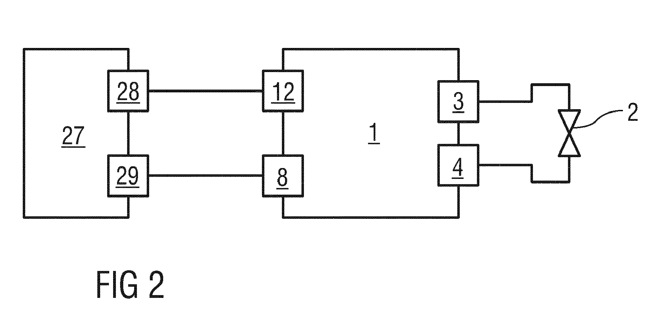

Figure 2 is a schematic drawing of an integrated circuit 1 connected with a solenoid 2 and an external controller 27. The integrated circuit 1 is drawn as a black box with the analog output for current sensing 12, the control output 8 and with the high and low side solenoid outputs 3, 4. Further inputs and outputs as well as internal building blocks of the integrated circuit 1 have been omitted for improved overview.

The solenoid 2 is connected between the high and low side solenoid outputs 3, 4.

The external controller 27 has a measuring input 28 adapted to measure a controlled variable of a closed control loop. The external controller 27 furthermore has a control output 29 adapted to provide an analog control voltage. The measuring input 28 and the control output 29 are connected with the analog output for current sensing 12 and with the control output 8, respectively. The external controller 27 may be formed as a microcontroller.

The external controller 27 measures the analog voltage provided by the analog output for current sensing 12 that indicates the instantaneous current through the solenoid 2. The external controller 27 thereby determines the instantaneous control deviation of this solenoid current from a pre-set solenoid current value. Depending on this instantaneous control deviation, the external controller 27 decreases or increases the analog control voltage at its control output 29, thereby decreasing or increasing the solenoid current driven by the integrated circuit 1 through the solenoid 2 until the pre-set solenoid current value is reached. Those skilled in the art will appreciate that various control algorithms such as a proportional-integral-derivative (PID) controller are known for implementing a closed control loop on the external controller 27 to control the solenoid current via the integrated circuit 1.

### List of references

- 1: integrated circuit
- 2: solenoid
- 3: high side solenoid output
- 4: low side solenoid output
- 5: digital supply voltage input
- 6: power stage voltage input
- 7: ground
- 8: control input
- 9: current regulation mode control input
- 10: input for current threshold set
- 11: digital fault detection output
- 12: analog output for current sensing
- 13: analog fault diagnosis output
- 14: high side switch
- 15: low side switch
- 16: freewheeling diode
- 17: internal oscillator
- 18: power control circuit
- 19: current source for current sense output
- 20: input logic
- 21: current source for current threshold input
- 22: high side current sensor
- 23: low side current sensor
- 24: analog current sensing resistor
- 25: current threshold set resistor
- 26: diagnosis sensing resistor
- 27: external controller
- 28: measuring input
- 29: control output

## Claims

1. An integrated circuit (1) adapted to drive a solenoid current through one solenoid (2) connectable between a high side solenoid output (3) and a low side solenoid output (4), the ASIC comprising
- an input logic (20) connected
- with a control input (8) switching the solenoid current,
- with a high side switch (14) controlling the high side solenoid output (3) and
- with a low side switch (15) controlling the low side solenoid output (4).

2. An integrated circuit (1) according to claim 1 comprising at least one current sensor (22, 23) measuring the solenoid current and a power control circuit (18) arranged between the input logic (20) and the high and low side switches (14, 15) for controlling the solenoid current to a solenoid current set-point value configurable by an input for current threshold set (10).

3. An integrated circuit (1) according to claim 2 comprising an internal oscillator (17) generating a pulse width modulated oscillation for controlling the solenoid current, wherein the frequency of the internal oscillator (17) is determined by a current regulation mode input (9) fed to the input logic (20).

4. An integrated circuit (1) according to claim 2 or 3 comprising a current source for current threshold input (21) controlled by the input for current threshold set (10) and providing a control current to the power control circuit (18), wherein the power control circuit (18) controls via the high and low side switches (14, 15) a solenoid current that is proportional to the control current.

5. An integrated circuit (1) according to claim 4, wherein the solenoid current set-point value is determined by a current threshold set resistor (25) connected between the input for current threshold set (10) and ground (7).

6. An integrated circuit (1) according to any of the claims 2 to 5, wherein the solenoid current is indicated by an indication current driven through an analog output for current sensing (12), the indication current being proportional to the solenoid current.

7. An integrated circuit (1) according to any of the claims 2 to 6, wherein the power control circuit (18) is adapted to detect and/or indicate a fault condition such as a short circuit of the high side solenoid output (3) to the power stage voltage input (6) or to the ground (7), a short circuit of the low side solenoid output (4) to the ground (7) or to the power stage voltage input (6), an over-current through a connected solenoid (2) or an over-voltage of the power voltage (6).

8. An integrated circuit (1) according to claim 7, wherein a high side current sensor (22) measures the current through the high side solenoid output (3) and/or a low side current sensor (23) measures the current through the low side solenoid output (4).

9. An integrated circuit (1) according to claim 7 or 8, wherein a fault condition is indicated by a digital fault detection output (11) controlled by the power control circuit (18).

10. An integrated circuit (1) according to claim 9, wherein a short circuit and/or an over-current and/or an over-voltage and/or an under-voltage is indicated by an analog fault diagnosis output (13) controlled by the power control circuit (18).

11. An integrated circuit (1) according to any of the claims 6 to 10 adapted to operate in a closed control loop for controlling the current through the high side solenoid output (3) and/or the current through the low side solenoid output (4).

12. An integrated circuit (1) according to claim 11, wherein
- the analog output for current sensing (12) is connectable to a measuring input (28) of an external controller (27) and
- the control input (8)is connectable to a control output (29) of the external controller (27).

13. An integrated circuit (1) according to any of the previous claims connected with a single solenoid (2) adapted to drive a valve in an automotive application.

14. An integrated circuit (1) according to claim 13, wherein the valve drives a gearbox actuator.
